# EUROPEAN PATENT APPLICATION

(11) **EP 4 475 171 A1**
(43) Date of publication of application: **11.12.2024**
(21) Application number: 23177568.5
(22) Date of filing: 06.06.2023
(51) Int. Cl.: H01L 21/768, H01L 23/522

(54) **A METHOD FOR PRODUCING AN INTERCONNECT VIA**

(71) Applicant: Imec VZW, 3001 Leuven (BE)
(72) Inventor: Park, Mr. Seongho, 3001 Heverlee (BE); Tokei, Mr. Zsolt, 3000 Leuven (BE); Marti, Mr. Giulio, 1050 Ixelles (BE)
(74) Representative: Patent Department IMEC

(57) **Abstract**

A stack of layers comprising, from bottom to top, a first conductive layer (2'), a second conductive layer (4') and a hardmask layer (6') is patterned resulting in parallel stacked lines (7), each stacked line comprising a first conductive line (2), a second conductive line (4) and a hardmask line (6). The hardmask lines are then patterned to form hardmask pillars (10) on the second conductive lines, the pillars being self-aligned to the lines. The second conductive lines are then etched relative to the hardmask pillars, thereby forming conductive pillars (12) self-aligned to first conductive lines (2). With the hardmask pillars still in place, interlayer dielectric material (15) is deposited and subsequently thinned until the hardmask pillars are exposed. The hardmask pillars are then removed relative to the conductive pillars, thereby forming cavities (16) which are subsequently filled by conductive material (17) that also covers the thinned dielectric layer. A further patterning step results in the formation of the upper lines (20) connected to the lower lines by one or more interconnect vias (19). Each interconnect via comprises a pillar portion (12,12') and a filled cavity portion (18,18') on top of the pillar portion.

## Description

### Field of the Invention

The present invention is related to semiconductor processing, in particular to the formation of interconnect vias between two levels of conductors of a multi-level interconnect structure.

### State of the art.

Semiconductor-based integrated circuits continue to evolve towards smaller and smaller dimensions, leading to ongoing processing challenges. Multilayer conductive structures are typically built as layers of arrays of parallel conductive lines, with interconnect vias formed between lines of the respective arrays. As dimensions shrink, traditional lithography and etch processes are no longer able to ensure acceptable alignment between an interconnect via and the underlying and overlying lines to which the via is connected.

A number of methods have been developed which enable self-alignment of a nano-sized interconnect via to both the underlying and overlying conductive (usually metal) lines. Patent publication document US2017256451 discloses a method wherein the metal lines of the lower level are formed by a patterning step using a hardmask in the form of a line array, and wherein the hardmask lines are maintained on the metal lines except at the via locations. At these locations, the hardmask is locally removed by a lithography and etching process to create a via opening, which is subsequently filled by a damascene-type metal fill process. In the resulting structure however, the remaining hardmask material increases the interlayer capacitance. Also, due to overlay errors in the lithography step applied for forming the via opening, the resulting interconnect via may be situated too close to an adjacent metal line.

Another approach is shown in patent publication document EP4050644. Here the hardmask material on top of the lower-level lines is removed, and via pillars are formed on top of said lower lines. The via pillars are subsequently embedded in a dielectric layer and fully or partially removed and replaced by metal, or according to an alternative the pillar is maintained and a trench is formed above the pillar, and subsequently filled with metal to form a line of the upper level. These various alternatives include a CMP step (chemical mechanical polishing) or an etch step, that stops on the upper surface of the via pillars, which for a number of metals such as Ru is not possible without affecting the pillar height in an uncontrollable way across a process wafer. Also, in the resulting interconnect structure, the via height is relatively low, leading to leakage issues between adjacent layers of the structure.

### Summary of the invention

The invention aims to provide a solution to the problems indicated hereabove. This aim is achieved by a method according to the appended claims. The invention is thus related to a method for producing interconnect vias for connecting one or more lower conductive lines to one or more upper conductive lines overlying the lower line or lines. Throughout this description and in the claims, the term 'conductive' is intended to refer to 'electrically conductive'.

A stack of layers comprising, from bottom to top, a first conductive layer, a second conductive layer and a hardmask layer is patterned, resulting in parallel stacked lines, each stacked line comprising a first conductive line, a second conductive line and a hardmask line. The hardmask lines are then patterned to form pillars of hardmask material (hereafter referred to as hardmask pillars) on the second conductive lines, the hardmask pillars being self-aligned to said second conductive lines. Outside these hardmask pillars, the hardmask lines are removed. The second conductive lines are then etched relative to the hardmask pillars, thereby forming conductive pillars self-aligned to the first conductive lines. With the hardmask pillars still in place, interlayer dielectric material is deposited and subsequently thinned until the hardmask pillars are exposed. The hardmask pillars are then removed relative to the conductive pillars, thereby forming cavities in the interlayer dielectric, which are subsequently filled by conductive material that also covers the thinned dielectric layer. A further patterning step results in the formation of the upper lines connected to the first conductive lines by one or more interconnect vias. Each interconnect via comprises a conductive pillar portion and a filled cavity portion on top of the pillar portion. The conductive pillar portion is self-aligned to the lower lines. Self-alignment of the filled cavity portion to the upper lines can be achieved by a suitable configuration of the lithography and etch steps performed for producing said upper lines.

The method is especially useful for the formation of interconnect vias which are nano-sized in three orthogonal directions, i.e. in terms of their width, length and height. The term 'nano-sized' in the present context is to be understood as: having at least one dimension of a few nanometers up to a few tens of nanometers. For example a nano-sized conductive line is a line having a nano-sized width and height.

The height of the conductive pillar portion is the same as the height of the second conductive layer. This pillar height is therefore very well controlled and it is furthermore not affected by any thinning step such as a CMP (chemical mechanical polishing) step. The latter aspect is advantageous as it enables the use of metals which cannot otherwise be used, such as Ru. Also, the second conductive layer can be for example a blanket metal layer produced by physical vapour deposition, which enables producing a layer having low resistivity. The conductive pillar portion can therefore be produced from low-resistivity material compared to a conductive pillar obtained by filling a small cavity. The combined height of the conductive pillar portion and the filled cavity portion is larger than the height of vias produced by prior art techniques, which is beneficial in terms of the interlayer capacitance. Another advantage compared to some prior art methods is that no hardmask material is left on top of the lower lines.

The invention is in particular related to a method for producing interconnect vias at respective intended locations thereof, for interconnecting one or more lower electrically conductive lines in a first level of a multi-level interconnect structure to one or more upper electrically conductive lines in a second level overlying said first level. At least some levels of the multi-level interconnect structure comprise nano-sized features. The method comprising the steps of:
- providing a substrate having an upper surface formed of a dielectric material with electrically conductive lines or contacts embedded in said dielectric material,
- producing on said upper surface a stack of layers comprising at least, from the bottom to the top: a first electrically conductive layer, a second electrically conductive layer, a hardmask layer,
- patterning the hardmask layer according to a pattern so as to form an array of parallel hardmask lines,
- etching the remaining layers of the stack relative to the hardmask lines, thereby obtaining an array of parallel stacked lines, each stacked line comprising from the bottom to the top : a first conductive line, a second conductive line, a hardmask line, wherein said first lines are forming said lower lines, and wherein one or more of said first lines are electrically connected to one or more of said electrical conductors or contacts embedded in said dielectric material. As a consequence of the production process for obtaining these stacked lines, each hardmask line is fully aligned to the underlying second conductive line and each second conductive line is fully aligned to the underlying first conductive line.
- by lithography and etching, patterning the hardmask lines so as to obtain at the intended location of each of the interconnect vias a hardmask pillar. Because the hardmask lines are fully aligned to the second conductive lines, each hardmask pillar is automatically self-aligned to the underlying second conductive line,
- etching the second conductive lines relative to the hardmask pillars, so as to obtain at each intended via location a conductive pillar and a hardmask pillar on top of the conductive pillar. Because the second conductive lines are fully aligned to the first conductive lines, each conductive pillar is automatically self-aligned to the underlying first conductive line producing a layer of dielectric material that fills up and covers the topography defined by the first conductive lines, the conductive pillars and the hardmask pillars,
- thinning the layer of dielectric material until the hardmask pillars are exposed,
- selectively removing the hardmask pillars relative to the underlying conductive pillars and relative to the layer of dielectric material, thereby forming cavities in the layer of dielectric material, above the respective conductive pillars,
- depositing a conductive material that fills up the cavities and forms a third conductive layer on the thinned layer of dielectric material,
patterning the third conductive layer so as to form the one or more upper conductive lines, one or more of said upper lines being electrically connected to one or more of the first, i.e. lower conductive lines, by interconnect vias which comprise a pillar portion and a filled cavity portion on top of the pillar portion. The pillar portions and thereby the interconnect vias as such are self-aligned to one of the lower conductive lines.

According to an embodiment, the patterning of the third conductive layer is performed in such a way that the upper lines are self-aligned to at least a top portion of the interconnect vias.

According to an embodiment, the stack of layers produced on the upper surface of the substrate further comprises an etch stop layer between the first conductive layer and the second conductive layer, said etch stop layer being configured to stop at least one etch process suitable for removing the material of the second conductive layer. In the latter case, the first and second conductive layers may be formed of the same material.

According to an embodiment, the second conductive layer is formed directly on the first conductive layer and the material of the second conductive layer is removable selectively with respect to the first conductive layer.

According to an embodiment, the stack of layers produced on the surface of the substrate further comprises an adhesion layer between the second conductive layer and the hardmask layer.

According to an embodiment, the step of thinning the layer of dielectric material includes a CMP (chemical mechanical polishing) step, stopping before reaching the top surfaces of the hardmask pillars, followed by an etch step relative to said hardmask pillars, so that at the end of the etch step, the hardmask pillars are partially extending outward from the upper surface of the thinned layer of dielectric material.

According to an embodiment, the second conductive layer is a low-resistivity layer formed by physical vapour deposition.

According to an embodiment, the interconnect vias have nano-sized dimensions in three orthogonal directions.

### Brief description of the figures

Figures 1 to 10 illustrate key steps of the method according to an embodiment of the invention.
Figures 11 and 12 show 2D sections illustrating an embodiment wherein the cavity above the conductive pillar is funnel shaped.
Figures 13 to 17 illustrate various embodiments of the formation of the conductive lines of the upper level, in a self-aligned manner relative to the interconnect vias produced in accordance with the invention.

### Detailed description of the invention

One embodiment of the method of the invention will now be described in detail. Any reference to material choices and dimensions is included by way of example only and does not limit the scope of the invention, which is defined only by the appended claims.

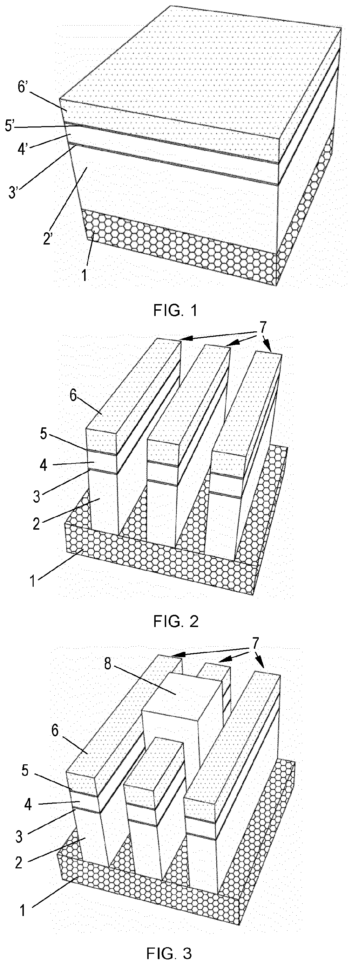

Figure 1 shows a small section of a substrate comprising a base portion 1 which may be a nano-sized upper slice of a silicon process wafer after the front end of line (FEOL) processing and part of the back end of line (BEOL) processing. As is known to the person skilled in the domain of semiconductor processing, the FEOL process constitutes a sequence of processing steps for producing large numbers of semiconductor devices such as transistors and diodes on usually a silicon wafer, according to the layout of several integrated circuit chips. BEOL processing adds a multi-level interconnect structure on top of the FEOL portion of the chips, said interconnect structure comprising multiple levels of electrically conductive lines, interconnected according to a predefined interconnection scheme by vertical interconnects, referred to in the present description as 'interconnect vias'. The interconnect levels are usually labelled Metal1, Metal2, etc (in short M1, M2, etc), as the line material is usually a metal such as Cu, W or Ru.

The top surface of the base portion 1 is formed of a dielectric material, for example SiO₂ or low-K dielectric onto which surface the conductive lines of a BEOL level Mx are to be formed. Embedded in said dielectric layer are electrically conductive lines or contacts, which may include conductive lines in level Mx-1, or interconnect vias intended to form an electrical contact between the lines of level Mx and the lines or contacts of level Mx-1, or local electrical contacts to source or drain electrodes of transistors of the FEOL portion if level Mx-1 is the deepest level of the BEOL stack for example.

The method of the invention includes method steps for forming the lines of levels Mx and Mx+1 and a plurality of interconnect vias interconnecting two lines of these levels Mx and Mx+1 for x = 1, 2, 3, ..

A number of layers are produced on the top surface of the base portion 1, as illustrated in Figure 1: a first electrically conductive layer 2', an etch stop layer 3', a second electrically conductive layer 4', an adhesion layer 5', and a hardmask layer 6'. The adhesion layer 5' is optional and may be omitted depending on the applied materials. For example, when the hardmask 6' layer is formed of SiN, a TiN adhesion layer is beneficial for securing pillars of SiN during a CMP (chemical mechanical polishing) step applied later in the method and described further on in this description. The etch stop layer 3' is required when layers 2' and 4' are formed of the same electrically conductive material. If these layers are formed of different materials, with the material of layer 4' being selectively removable relative to the material of layer 2', the etch stop layer 3' is not required.

The thicknesses of the various layers depend on the metallization levels to which the method is applied, i.e. the value of x. The method of the invention is applicable down to the deepest levels and provides the most benefits at these levels given the importance of controlling the via height and alignment at the nano-sized dimensions applicable at these deep levels. For example for x= 2 (production of interconnect vias between M2 and M3), the following thicknesses may be applied: thickness of layer 2': 30 nm, thickness of the etch stop layer 3': 0.3 nm, thickness of the layer 4': 10 nm, thickness of the adhesion layer 5' : 1 nm, thickness of the hardmask layer 6' : 25 nm.

By way of example only, the following materials may be applied: Ru for layers 2' and 4', TiN for the etch stop layer 3' and the adhesion layer 5', SiN for the hardmask layer 6'.

Layer 4' may be a blanket metal layer produced by physical vapour deposition (PVD). Such a layer has lower resistivity than metal deposited in a via opening by a damascene-type metal fill technique which is typically done by other deposition techniques, for example chemical vapour deposition (CVD) or atomic layer deposition (ALD). Filling metal in a small via opening results in metal having a smaller grain size and therefore a higher resistivity than metal applied in a blanket layer.

With reference to Figure 2, the stack of layers is patterned to form parallel stacked lines 7, each stacked line comprising from the bottom to the top: a first conductive line 2, an etch stop layer 3, a second conductive line 4, an adhesion layer 5 and a hardmask line 6. The first conductive lines 2 will eventually become the lines of the lower BEOL level Mx. The formation of the stacked lines 7 may be done by first patterning the hardmask layer 6' by lithography and etching. The line pattern of the patterned hardmask is then transferred to the underlying layers of the stack by etching through these layers relative to the hardmask lines 6. This may be achieved according to processes and using tools well known in the art for various known combinations of materials and feature dimensions, which processes need therefore not be described here in detail.

The image in Figure 2 assumes that the etch process is 100% anisotropic, i.e. the sidewalls of the lines 7 are perpendicular to the surface of the base portion 1. In reality, the width of the lines may taper outwards slightly towards the base of the lines. In the process for producing levels M2 and M3, the width at the top of the lines 7 and the pitch of the line array may be in the order of 9nm (i.e. gap between the lines is also in the order of 9 nm).

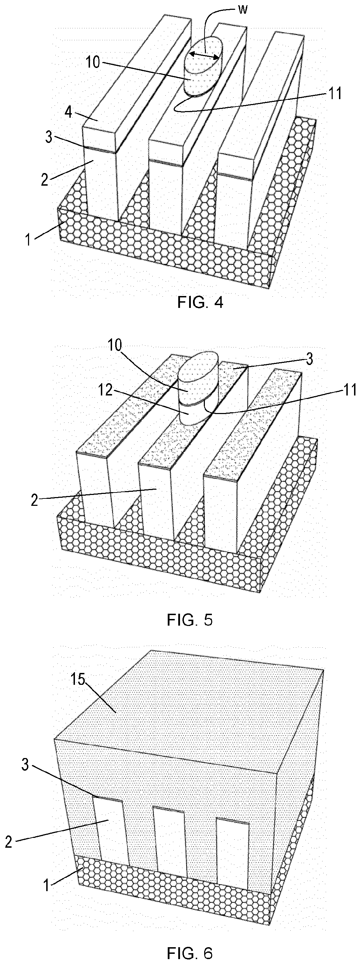

With reference to Figure 3, the hardmask lines 6 are subjected to a further patterning step, wherein local mask portions 8 are formed across and overlapping the width of the stacked lines 7, at the intended locations of the interconnect vias between Mx and Mx+1. Only one of these locations is represented in the small depicted area. A high number of these locations are normally included in the deeper levels of the BEOL design. With these mask portions 8 in place, the exposed portions of the hardmask lines 6 are removed. After stripping the local mask portions 8, and as illustrated in Figure 4, this leaves local pillars 10 consisting of the hardmask material on a thin adhesive layer 11, on top of the second conductive lines 4. As stated, the adhesion layer 11 is optional, so the hardmask pillars 10 may be present directly on the conductive lines 4. In Figure 4 the hardmask pillar 10 is shown as having an ellipse-shape as a consequence of a difference in the etch rate in the directions parallel and orthogonal to the lines 7 during the removal of the material of the hardmask line 6 on either side of the pillar 10. The actual shape may be closer to rectangular or another shape. In any case, because the hardmask pillar 10 is formed by etching the hardmask line 6 which is aligned to the underlying conductive line 4, the pillar 10 is self-aligned to said underlying conductive line 4, i.e. it cannot go beyond or be misaligned to the width of this conductive line 4. Preferably, the lithography and etch process for forming the hardmask pillars 10 is such that the width w of the hardmask pillar 10 is equal to the width of the lines 4, as shown in Figure 4, but this width w could also be smaller than the width of the lines 4, provided that a width of the hardmask pillar 10 is realized that enables to obtain suitable dimensions of the eventual interconnect via.

By way of example, the length of the hardmask pillar 10 may be in the order of twice the width, i.e. about 20 nm for x =2. However, the invention is not limited to any dimensions nor to any particular shape of the hardmask pillars 10.

As shown in Figure 5, the next step consists of etching back the second conductive lines 4 relative to the hardmask pillars 10, by an essentially anisotropic etch process that transfers the shape of the hardmask pillars 10 to the conductive material of the lines 4, forming at each intended via location a conductive pillar 12 having essentially the same (in this case ellipse shaped) cross-section as the hardmask pillar 10 The etch process stops on the etch stop layers 3, i.e. the etch stop function of these layer 3 (and the initial full layer 3') is related to the etch process used in this step of the method. As stated, if the material of layer 4' is different from and selectively removable relative to the material of layer 2', the etch stop layer 3 is not required. In that case, the conductive pillar 12 may be obtained by etching the material of the line 4 and stopping on the upper surface of line 2.

As the conductive pillar 12 is a part of the second conductive line 4 which is aligned to the underlying first conductive line 2, the conductive pillar 12 is self-aligned to said first conductive line 2, i.e. the pillar 12 cannot go beyond or be misaligned to the width of the lines of level Mx. Due to the particular sequence of steps, the self-alignment of the conductive pillar 12 to the lower lines 2 is achieved in combination with a perfect control of the height of the conductive pillars 12, said height being defined by the height of the initial conductive layer 4'. Also, when layer 4' is a low-resistivity layer, this low resistivity is preserved in the conductive pillars 12.

At this point, a further lithography and etch sequence may be applied for interrupting the lines 2 in accordance with a particular BEOL layout, and at locations outside the locations of the pillars 12. This is not shown in the drawings, and may be performed according to known methods.

In the embodiment shown, the etch stop layer 3 remains on top of the conductive lines 2, which is possible provided that this etch stop layer 3 is electrically conductive, as is the case in the above-cited example of the materials, with TiN used for the etch stop layer 3. In alternative embodiments, this etch stop layer 3 is removed selectively with respect to the underlying conductive lines 2, prior to the next method step described hereafter.

With reference to Figure 6, a layer 15 of dielectric material is now deposited on the full substrate, covering and filling up the topography defined by the lines 2 and the stacks comprising each a conductive pillar 12 and a hardmask pillar 10. With the terminology 'filling up the topography', it is meant that the dielectric material enters every spacing between the lines 2 and fully envelops the stacks of hardmask pillars 10 and conductive pillars 12. The term 'filling up' however does not exclude the formation of air gaps. As known in the art, it may be possible that such air gaps are formed in the dielectric material between the lines 2. These air gaps may be intentionally formed as they improve the electrical isolation between adjacent lines.

The dielectric material used for layer 15 is a material that is suitable for use as interlayer dielectric in a BEOL interconnect structure. It may be a SiO₂ or a low-K dielectric known as such in the art. Methods for depositing this material are also well known and need therefore not be described here in detail.

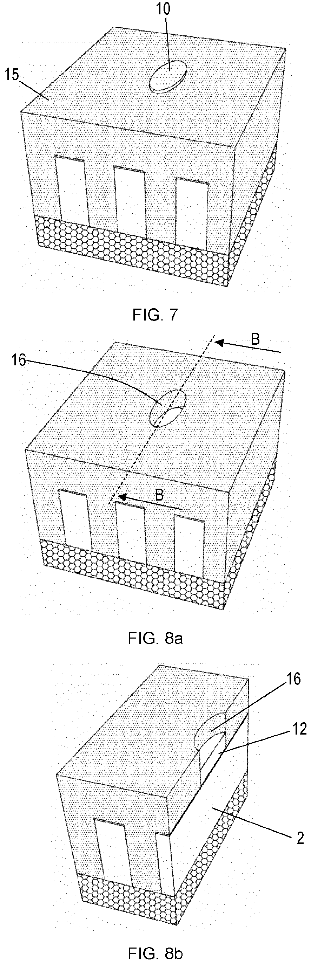

The dielectric layer 15 is subsequently thinned by CMP (chemical mechanical polishing), which may either stop on the top surfaces of the hardmask pillars 10, or before reaching said top surfaces. In the latter case, an additional dry etch process is applied, further thinning the dielectric layer until the hardmask pillars 10 extend slightly (for example in the order of 1 nm or less) above the thinned dielectric surface, as illustrated in Figure 7. The latter approach is preferred given that the CMP process in that case does not directly affect the hardmask pillars 10, thereby minimizing the impact of the CMP on these pillars in terms of unwanted thinning of the hardmask pillars 10 or releasing them from the underlying conductive pillars 12, for example if no adhesion layer 11 is applied.

In any case, the above-described approach ensures that the CMP process never directly affects the conductive pillars 12 themselves, so that the height of these pillars is preserved across the full substrate surface.

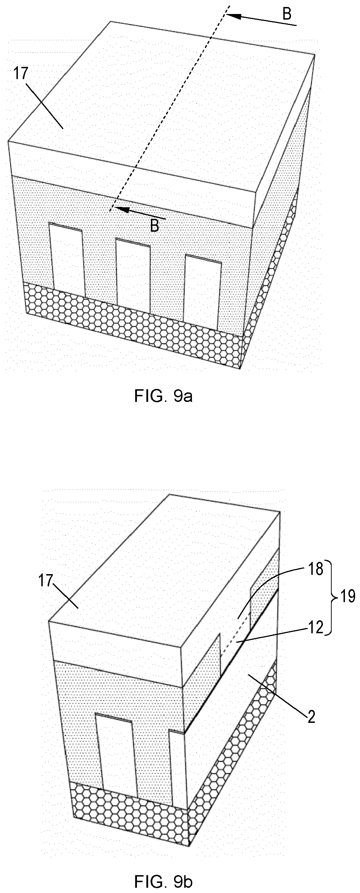

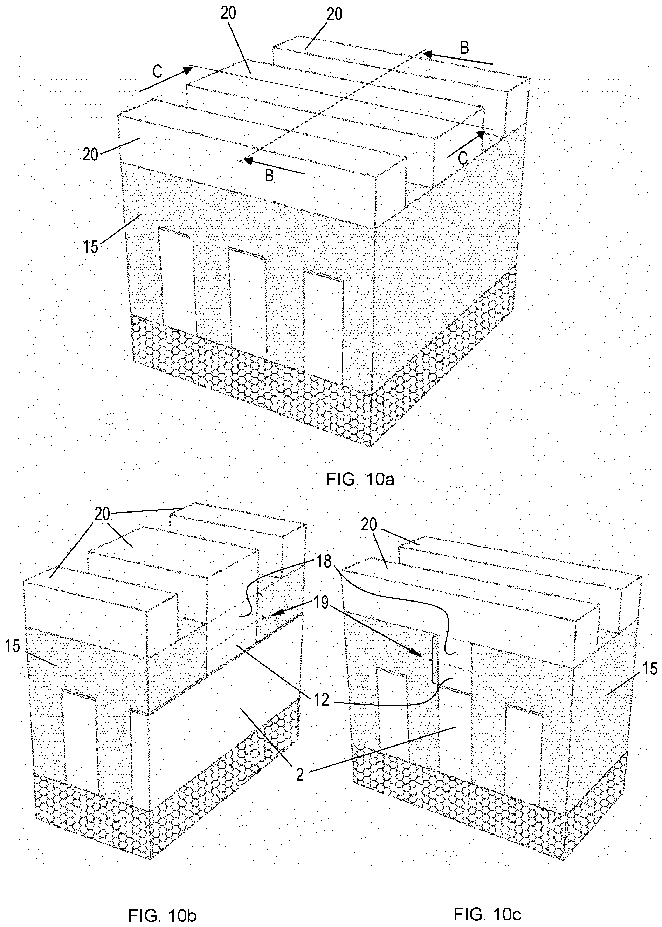

In the next step, illustrated in Figure 8a and the section view in Figure 8b, the hardmask pillar 10 is selectively removed relative to the surrounding dielectric layer 15, thereby creating a cavity 16, or a plurality of cavities 16 at the multiple intended via locations. If present, the adhesion layer 11 may equally be removed selectively with respect to the conductive pillar 12, as illustrated in the drawing, i.e. the top surface of the conductive pillar 12 is exposed at the bottom of the cavity 16. If the adhesion layer 11 is electrically conductive, this layer may however also remain on the pillar 12. In the images shown, the cavity 16 obtained after the removal of the hardmask pillar 10 and the adhesion layer 11 has essentially the same cross-section as the hardmask pillar 10 itself, i.e. the cavity 16 has essentially vertical sidewalls. According to other embodiments, the cavity may have a wider profile due to the fact that an oxidation layer has formed on the sidewalls of the hardmask pillar 10 and on the bottom of the cavity 16 which needs to be removed before the cavity can be filled with conductive material. The removal of this oxidation layer may result in the at least partial widening of the cavity into a funnel shape. This funnel shape falls within the scope of the invention and will be described in more detail later in this description. First however the embodiment with vertical sidewalls of the cavity 16 will be further described with reference to Figures 9a/9b and 10a/10b.

As shown in Figures 9a and 9b, a conductive material is produced on the full substrate, filling the cavities 16 and forming a conductive layer 17 on the substrate. Prior to this filling step, a thin conformal layer (not shown) could be deposited on the substrate, lining the bottom and sidewalls of the cavities 16. This could be an adhesion layer or a barrier layer or a stack of different layers having different functions. Said function and the materials and application methods of such conformal layers is well known.

The step of filling the cavities 16 and forming conductive layer 17 is a standard damascene type process, wherein the filling of the cavities 16 results in the formation of an interconnect via 19. As illustrated in the section view in Figure 9b, the via comprises the conductive pillar 12 at the base and on top of the conductive pillar 12, a via portion 18 obtained by filling the cavity 16 with conductive material.

Possibly after planarizing the conductive layer 17 to the required thickness (not shown), this conductive layer 17 is then subjected to a patterning step, illustrated in Figures 10a to 10c, forming the conductive lines 20 of the upper BEOL level Mx+1 (only the central line 20 is shown at its full width, the outer lines are only shown partially in the small 3D section). In the example shown, the upper lines 20 are oriented cross-wise relative to the lower lines 2. The upper lines could 20 however also be oriented parallel to the lower lines 2 or have any other orientation.

The interconnect via 19 connects the lower conductive line 2 to an upper conductive line 20. In the wording of the appended claims, the interconnect via 19 comprises a conductive pillar portion 12 and a filed cavity portion 18. In the image shown, the width of the upper conductive line 20 is equal to the length of the via 19 and perfectly aligned to said length without removing any material of the via itself. In other words, material of the via 19 is not removed by the etch process for forming the conductive lines 20. This is a rather theoretical case and in reality the patterning of conductive layer 17 preferably takes place in such a way that the conductive line 20 is self-aligned to at least a top portion of the via 19, by at least partially removing lateral portions of the via. A few examples of the latter approach will be described later in this description.

From the situation shown in Figures 10a-10c, and unless the lines 20 form the upper level of the BEOL structure, the BEOL process continues, starting with further patterning the lines 20 according to the BEOL layout, and further including the deposition of dielectric material in the space between the lines 20 and on top of the lines 20. Then the subsequent levels Mx+2, Mx+3, etc are processed, possibly applying again the method of the invention for producing interconnect vias between conductive lines of two adjacent levels.

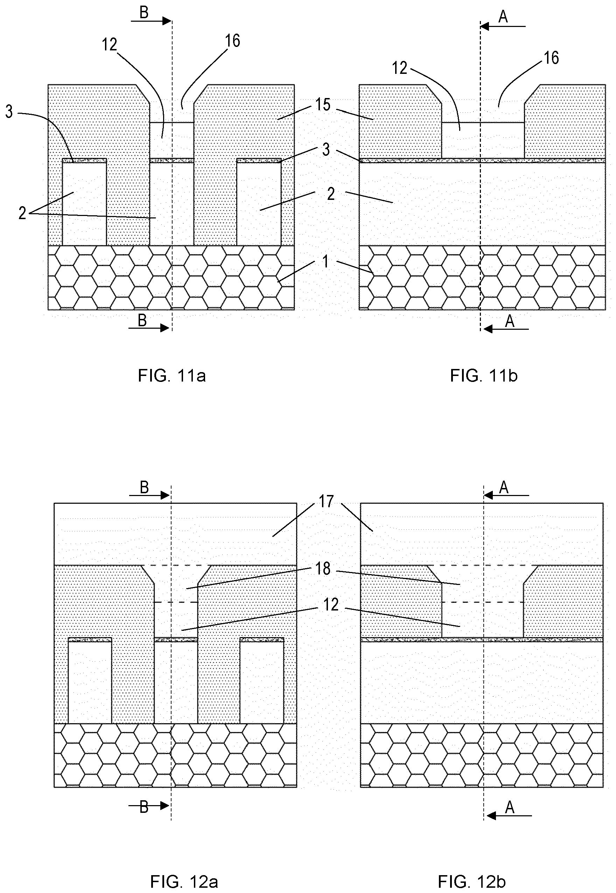

The above-described funnel-shape of the cavity 16 is illustrated in the two section views represented in Figures 11a and 11b. This may be the result of a wet etch process for removing an oxide layer from the bottom of the cavity 16. Some etch recipes will inevitably etch the sidewalls of the cavity according to a funnel-shaped profile as shown or similar thereto. Also, the top surface of the dielectric layer 15 may be slightly etched back so that the height of the cavity may be slightly reduced at the end of this etch process. Etch recipes for removing an oxide layer from the bottom of a cavity are known as such and therefore not described in detail here.

Figures 12a and 12b illustrate the subsequent step of filling the cavity 16 with conductive material and forming the conductive layer 17 of said same conductive material. The conductive material fills the funnel shape completely resulting in the conductive pillar 12 and filled cavity 18.

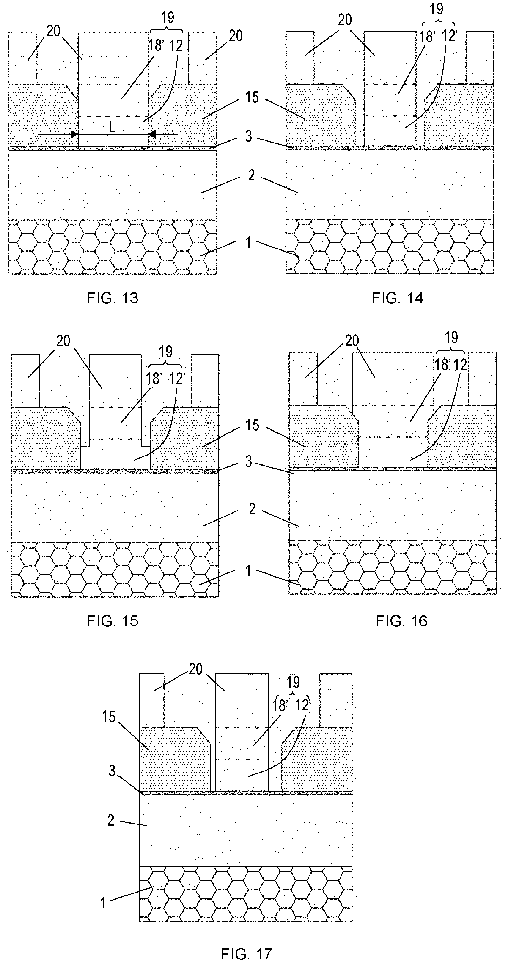

Regardless of whether or not the cavity 16 has a funnel shape, the steps of filling the cavities 16 with conductive material and forming the conductive layer 17 followed by patterning this layer to form the upper conductive lines 20 are known as such, and can be performed according to prior art techniques. Self-alignment of the upper lines 20 to at least a top portion of the interconnect vias 19 may be obtained in a number of ways, examples of which are shown in Figures 13 to 17.

In Figure 13, litho and etch steps for forming the lines 20 are performed so that the lines 20 are perfectly aligned to the length L of the conductive pillar 12. The 'pillar portion' thus corresponds to the conductive pillar 12, while the 'filled cavity portion' 18' now corresponds to the filled cavity 18 minus removed lateral portions thereof. This may be difficult to obtain in reality because of an unavoidable overlay error and the difficulty of stopping the etching of the lines 20 exactly as illustrated.

In Figure 14, the width of the lines 20 is smaller and the etch process continues down to the etch stop layer 3, removing lateral portions of the interconnect via 19 including portions of the conductive pillar 12. The result is that the upper line 20 is perfectly aligned to the via 19. Both the 'pillar portion' 12' and the filled cavity portion 18' are shorter than the original conductive pillar 12 and filled cavity 18. With the same line width of lines 20, it is however possible to etch only partly down, as illustrated in Figure 15, so that the upper line 20 is aligned to the 'filledcavity portion' 18' of the via 19 while the 'pillar portion' 12' now has a higher length at the base than at the top. Figure 16 shows an example wherein the line width exceeds the length of the conductive pillar 12 and etching is stopped at a point where part of the funnel shape is maintained in the final via 19, i.e. the 'filledcavity portion' 18' is marginally shorter at the top than the original filled cavity 18. Further alternatives are possible. Also, the examples shown assume that no overlay error is made in the placement of the lines 20 relative to the length L of the vias 19. The design of the lines 20 should take into account such overlay errors, so that the desired self-alignment is obtained, as illustrated for example in Figure 17 for the case of the self-alignment by etching down to the etch stop layer 3.

As stated, the method is not limited to producing lower and upper conductive lines oriented cross-wise relative to each other. The upper lines could be oriented parallel to the lower lines for example. Self-alignment of the upper lines relative to the interconnect vias 19 can be done as described above, regardless of the relative orientation of the upper and lower lines.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to an advantage. Any reference signs in the claims should not be construed as limiting the scope.

Unless specifically specified, the description of a layer being present, deposited or produced 'on' another layer or substrate, includes the options of
- said layer being present, produced or deposited directly on, i.e. in physical contact with, said other layer or substrate, and
- said layer being present, produced or deposited on one or a stack of intermediate layers between said layer and said other layer or substrate.

## Claims

1. A method for producing interconnect vias (19) at respective intended locations thereof, for interconnecting one or more lower electrically conductive lines (2) in a first level of a multi-level interconnect structure to one or more upper electrically conductive lines (20) in a second level overlying said first level, the method comprising the steps of:
- providing a substrate (1) having an upper surface formed of a dielectric material with electrically conductive lines or contacts embedded in said dielectric material,
- producing on said upper surface a stack of layers comprising at least, from the bottom to the top: a first electrically conductive layer (2'), a second electrically conductive layer (4'), a hardmask layer (6'),
- patterning the hardmask layer according to a pattern so as to form an array of parallel hardmask lines (6),
- etching the remaining layers of the stack relative to the hardmask lines (6), thereby obtaining an array of parallel stacked lines (7), each stacked line comprising from the bottom to the top : a first conductive line (2), a second conductive line (4), a hardmask line (6), wherein said first lines (2) are forming said lower lines, and wherein one or more of said first lines (2) are electrically connected to one or more of said electrical conductors or contacts embedded in said dielectric material,
- by lithography and etching, patterning the hardmask lines (6) so as to obtain at the intended location of each of the interconnect vias a hardmask pillar (10),
- etching the second conductive lines (4) relative to the hardmask pillars (10), so as to obtain at each intended via location a conductive pillar (12) and a hardmask pillar (10) on top of the conductive pillar,
- producing a layer (15) of dielectric material that fills up and covers the topography defined by the first conductive lines (2), the conductive pillars (12) and the hardmask pillars (10),
- thinning the layer (15) of dielectric material until the hardmask pillars (10) are exposed,
- selectively removing the hardmask pillars (10) relative to the underlying conductive pillars (12) and relative to the layer (15) of dielectric material, thereby forming cavities (16) in the layer (15) of dielectric material, above the respective conductive pillars (12),
- depositing a conductive material that fills up the cavities (16) and forms a third conductive layer (17) on the thinned layer (15) of dielectric material,
- patterning the third conductive layer (17) so as to form the one or more upper conductive lines (20), one or more of said upper lines being electrically connected to one or more of the first, i.e. lower conductive lines (2), by interconnect vias (19) which comprise a pillar portion (12,12') and a filled cavity portion (18,18') on top of the pillar portion.

2. The method according to claim 1, wherein the patterning of the third conductive layer (17) is performed in such a way that the upper lines (20) are self-aligned to at least a top portion of the interconnect vias (19).

3. The method according to claim 1 or 2, wherein the stack of layers produced on the upper surface of the substrate (1) further comprises an etch stop layer (3') between the first conductive layer (2') and the second conductive layer (4'), said etch stop layer being configured to stop at least one etch process suitable for removing the material of the second conductive layer (4').

4. The method according to claim 3, wherein the first and second conductive layers (2',4') are formed of the same material.

5. The method according to claim 1, wherein the second conductive layer (4') is formed directly on the first conductive layer (2') and wherein the material of the second conductive layer (4') is removable selectively with respect to the first conductive layer (2').

6. The method according to any one of the preceding claims, wherein the stack of layers produced on the surface of the substrate (1) further comprises an adhesion layer (5') between the second conductive layer (4') and the hardmask layer (6').

7. The method according to any one of the preceding claims wherein the step of thinning the layer (15) of dielectric material includes a CMP (chemical mechanical polishing) step, stopping before reaching the top surfaces of the hardmask pillars (10), followed by an etch step relative to said hardmask pillars, so that at the end of the etch step, the hardmask pillars (10) are partially extending outward from the upper surface of the thinned layer (15) of dielectric material.

8. The method according to any one of the preceding claims, wherein the second conductive layer (4') is a low-resistivity layer formed by physical vapour deposition.

9. The method according to any one of the preceding claims, wherein the interconnect vias (19) have nano-sized dimensions in three orthogonal directions.
